(19) Europäisches Patentamt
European Patent Office
Office européen des brevets

(11) **EP 1 469 373 B1**

(12) **EUROPEAN PATENT SPECIFICATION**

(45) Date of publication and mention
of the grant of the patent:
**14.03.2007 Bulletin 2007/11**

(51) Int Cl.:
*G06F 1/03* (2006.01)

(21) Application number: **03008937.9**

(22) Date of filing: **16.04.2003**

(54) **Direct digital frequency synthesizer for cellular wireless communication systems based on fast frequency-hopped spread spectrum technology**

Direkter digitaler Frequenzsynthetisierer für ein zellulares schnurloses Kommunikationssystem basierend auf schneller Frequenzsprung-Spreizspektrum-Technologie

Synthétiseur de fréquence numérique direct pour un système de communication cellulaire sans fil basé sur la technologie de sauts de frequence rapide à spectre étalé

(84) Designated Contracting States:
**AT BE BG CH CY CZ DE DK EE ES FI FR GB GR HU IE IT LI LU MC NL PT RO SE SI SK TR**

(43) Date of publication of application:
**20.10.2004 Bulletin 2004/43**

(73) Proprietor: **Sony Ericsson Mobile Communications AB**
**221 88 Lund (SE)**

(72) Inventor: **Repin, Alexander,**
**Sony Ericsson Mob. Com. Int. AB**
**85609 Aschheim-Dornach (DE)**

(74) Representative: **Rupp, Christian et al**
**Mitscherlich & Partner**
**Patent- und Rechtsanwälte**
**Sonnenstrasse 33**
**80331 München (DE)**

(56) References cited:
**EP-A- 0 452 031**

- **REINHARDT V S: "Spur reduction techniques in direct digital synthesizers" FREQUENCY CONTROL SYMPOSIUM, 1993. 47TH., PROCEEDINGS OF THE 1993 IEEE INTERNATIONAL SALT LAKE CITY, UT, USA 2-4 JUNE 1993, NEW YORK, NY, USA,IEEE, 2 June 1993 (1993-06-02), pages 230-241, XP010126102 ISBN: 0-7803-0905-7**

**Description**

FIELD AND BACKGROUND OF THE INVENTION

The underlying invention generally relates to the field of direct digital frequency synthesizer (DDFS) architectures used for generating a numerically controlled oscillator signal with an approximately sinusoidal waveshape, that can advantageously be applied to wireless RF transceivers in a cellular communication system based on a fast frequency-hopped spread spectrum (FHSS) technology. The invention particularly refers to a method for reducing spurious harmonics, voltage and current glitches in the frequency synthesizer's noise power density spectrum caused by phase truncation and amplitude quantization errors as well as non-idealities of the applied digital-to-analog converters that introduce jitter into the output waveform of the DDFS.

Today, the generation of accurate sine waveforms plays a crucial role in almost all electronic equipment, from sophisticated radar systems to wireless communication devices and home entertainment equipment such as car radios and stereo systems. For example, the carrier frequency generated by an integrated oscillator of a wireless RF transceiver must be defined with a very high absolute accuracy. This frequency has to be varied in small, precise steps since modem communication systems and standards which are based on fast frequency-hopped spread spectrum (FHSS) technology (e.g. Bluetooth) require fast and precise tuning over a wide bandwidth. Frequency synthesizers used in conventional cellular wireless communication systems hence often employ phase-locked loop (PLL) circuitries, which reduce the noise power level and the power level of spurious harmonics in the output spectrum of the synthesized signal.

Parallel to the rapid advance of conventional phase-locked loop (PLL)-based frequency synthesis - a feedback mechanism where the output frequency of a frequency synthesizing unit (FSU) is locked to a frequency reference, which gained popularity due to its simplicity and economics -, other frequency synthesis techniques, which are mainly digital in nature, have emerged: direct digital synthesis (DDS) and fractional-N PLL synthesis. Thereby, a classical PLL frequency synthesizer is being supplemented with a digital signal processor (DSP). Indeed, the application of DSP techniques to frequency synthesis is still at an early stage. The generation of sine waves by using digital methodologies requires the generation of the waveform from the ground up. This is fundamentally different from a conventional PLL synthesizer, where an analog signal is generated by at least one local oscillator.

Another widespread frequency synthesizer technique is known as direct analog (DA) frequency synthesis. In this technique, a group of reference frequencies is derived from the main reference; these frequencies are mixed, filtered, and arithmetically combined according to the required output. However, there are no feedback mechanisms in the basic technique. DA frequency synthesis offers excellent spectral purity, especially close to the carrier frequency, and an excellent switching speed, which is a critical parameter in many designs and determines how fast the synthesizer can hop from one frequency to another. The DA technique is usually much more complicated than PLL to execute and is therefore more expensive. DA synthesizers have found applications in medical imaging and spectrometers, fast-switching anti-jam communications and radar, electronic warfare (EW) simulation, automatic test equipment (ATE), radar cross-section (RCS) measurement, and applications where the advantages of the DA technique are a must at a premium cost.

Direct digital synthesis (DDS) is an emerging and maturing signal generation technology which uses digital signal processing (DSP) to digitally create, manipulate and modulate a signal. The digital signal can then be converted to a quantized analog form by means of a digital-to-analog converter (DAC). Although direct digital frequency synthesizers (DDFS), sometimes also referred to as numerically controlled oscillators (NCOs), were invented more than 30 years ago, they started to attract attention only in the last 10 to 12 years. Due to the rapid evolution of digital technology and its tools, DDS technique evolved remarkably to an economical, high-performance tool and is now a major frequency synthesis technique, which is used by almost all synthesizer designers from instrument makers to applications such as satellite communications, radar, medical imaging, cellular telephony and amateur radios, and its performance is constantly enhanced.

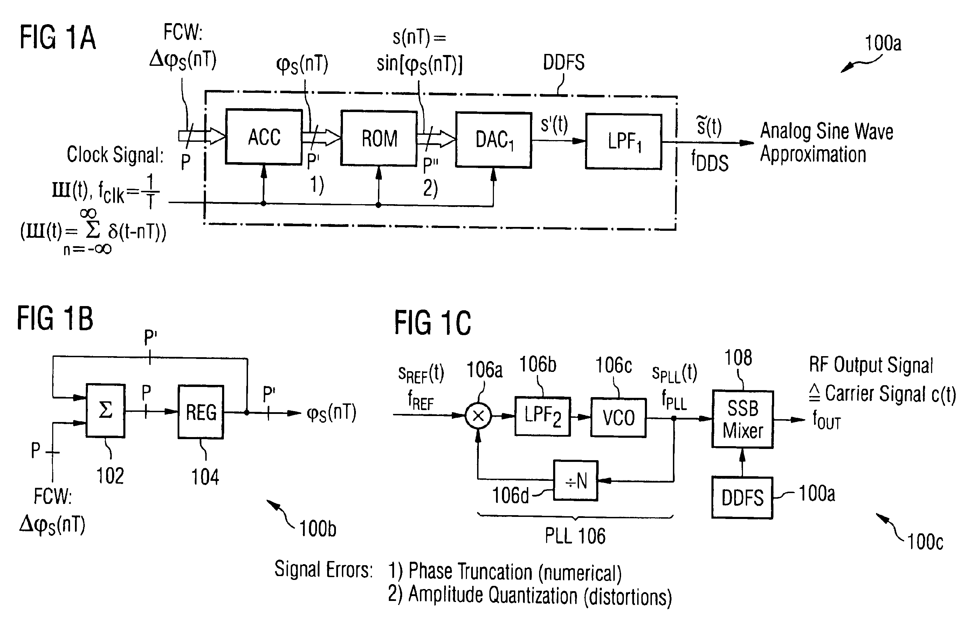

Direct digital frequency synthesizers (DDFS) generate waveforms of periodical nature by using digital and analog signal processing blocks. Open-loop DDFS architectures are particularly employed for generating precise, fast frequency- and phase-tunable output signals. Conventional DDFS circuitries are implemented in large-scale integration (LSI), and they play a an ever-increasing role in digital waveform and agile clock signal generation and modulation. A block diagram of a typical DDFS architecture is shown in Fig. 1a. The depicted DDFS includes a phase accumulator (ACC), a lookup table (LUT) realized in form of a read-only memory (ROM), which converts discrete phase values $\varphi_s$ (nT) into discrete sine amplitude sample values s(nT), and a digital-to-analog converter (DAC), followed by a low-pass filter (LPF). The system has two input signals: a clock reference

$$\varnothing\,(t)\;:=\;A_\delta\cdot\sum_{n\,=\,-\infty}^{+\infty}\delta\left(t-nT\right)\;\;\text{with}\;\;T=\frac{1}{f_{clk}},$$

wherein

$A_\delta$ [V]     is the amplitude value of the clock signal (here: $A_\delta := 5$ V),
$f_{clk}$ [MHz]     denotes the clockrate of an oscillator circuit,
$n$         is the sampling index.,
$T$ [ns]     denotes the sampling interval, and
$\delta(t-nT)$     denotes a Dirac impulse with amplitude '1' at the discrete time $nT$,

and a frequency control word $\Delta\varphi_s(nT)$ (FCW). The phase accumulator (ACC) integrates the value of the FCW every clock cycle, thereby producing a periodically repeated discrete ramp signal $\varphi_s(nT)$ whose slope is directly proportional to the FCW. When the accumulator exceeds a value equivalent to $2\pi$ radians, it overflows, multiples of $2\pi$ are discarded, and the incrementation process continues to the next cycle. In order to generate the desired output waveform

$$s(t)\;:=\;A_s\cdot sin\left[\omega_s(t)\cdot t+\varphi_{s0}\right]\;\text{with}\;\omega_s(t)=2\pi\cdot f_s(t)=\frac{d\varphi_s(t)}{dt},$$

wherein

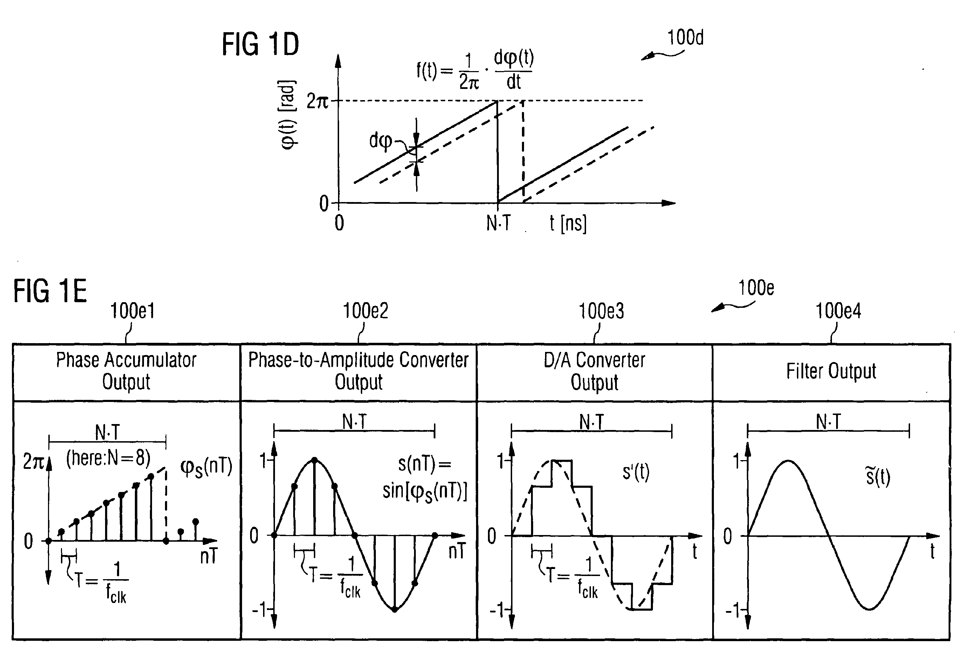

$A_s$ [V]         is the signal amplitude of the desired analog output waveform $s(t)$,
$\varphi_s\,(t)\,[rad]$         is the signal phase, which is a sawtooth function as shown in Fig. 1d,
$\varphi_{s0}\,[rad]$         denotes the initial phase of the output waveform $s(t)$ at the time $t = 0$ ns (here: $\varphi_{s0} := 0$ rad), and
$\omega_s\,(t)\,[rad\cdot s^{-1}]$     is the angular frequency of said output waveform $s(t)$,

it is necessary to convert the phase accumulator output into an approximated sine amplitude

$$s(nT)\;:=\;\sin\left[\varphi_s\left(nT\right)\right]\;\;\forall\;n,$$

wherein T [ns] denotes the sampling interval and n is the sampling index.

For this purpose, the number held in the phase accumulator (ACC) is used to address a lookup table (LUT) held in a read-only memory (ROM) which converts said phase information to a series of discrete, digitized amplitude samples of a sine wave. A digital-to-analog converter (DAC$_1$), followed by a low-pass filter (LPF), converts the sequence of the resultant sinusoid sample values $s(nT)$ into an analog sine wave approximation $\tilde{s}(t)$. The LPF thereby removes spurious aliasing harmonics and causes the signal to appear smooth as illustrated in Fig. 1e.

Thereby, it should be noted that the signal is synthesized from the ground up. For this reason, it is relatively easy to add phase shifting, frequency changes, and amplitude modulation, all in the digital domain and with digital accuracy. The phase accumulator (ACC) is a digital integrator which produces a linear output ramp whose slope (the rate of change) is given by the frequency control word $W$. This device is used to generate the phase signal $\varphi_s(nT)$, wherein $T$ is the sampling time and depends on the clockrate $f_{clk}$ of an oscillator circuit connected to the accumulator. The accumulator (ACC) is thereby operating as an indexer whose output signal $\varphi_s(nT)$ controls the input to the sine lookup table (LUT). It can be viewed as a complex counter, which can easily be controlled. On the assumption that the phase accumulator size is $P = 32$ bit, the device accumulates from 0 to $2^{32}-1$. Obviously, above this number the accumulator will overflow and restart from zero phase. The rate of accumulation depends only on the clock rate $f_{clk} = 1/T$ and the control word $W$. And $W$ can be as low as 0 - in this case the accumulator will not increment (equivalent to generating a DC signal) - or any arbitrary number $W < 2^P-1$, which is the case if all the $P$ input bits are equal to 1. If the value '0' is associated with zero phase and '$2^{32}-1$' with $2\pi$ radians, the phase accumulator (ACC) periodically generates phases from 0 to $2\pi$ radians (as the device operates modulo $2^{32}$).

For a demonstration of the operation of the accumulator, it shall be assumed that a phase accumulator with an accumulator size of $P' = 32$ bit is clocked at $f_{clk} = 2^{32}/10$ Hz. Then, if $W := 1$, it will take exactly 10 s (which means $2^{32}$ clock ticks) to generate phases from 0 to $2\pi$. However, if $W := 230$, it will take only $40/2^{32}$ s = $10/2^{30}$ s (which means four clock ticks). Obviously, $W$ controls the rate of change of the accumulator, and the rate of change of the phase is the frequency $\omega_s$. In the above example, for $W := 1$, the cycle is 0.1 Hz, while for $W := 2^{30}$ the cycle is equal to $2^{30}/10$ Hz or $f_{clk}/4$ Hz. Assuming an $P'$-bit-wide phase accumulator, the obtained output frequency thus yields

$$f_{DDS} = 2\pi \cdot \frac{d\varphi_s(t)}{dt} = \frac{W}{2^{P'} \cdot T} = \frac{f_{clk} \cdot W}{2^{P'}} \text{ with } T = \frac{1}{f_{clk}},$$

wherein

$f_{DDS}$ [MHz]   is the obtained frequency at the output port of the DDFS,
$P'$ [bit]   denotes the size of the applied phase accumulator (ACC) and thus the wordlength of the obtained phase sample values $\varphi_s(nT)$, and
$W$   is the decimal representation of the frequency control word $\Delta\varphi_s(nT)$.

The phase information is connected to the ROM which converts $\varphi_s(nT)$ to $sin[\varphi_s(nT)]$. Since the accumulator is usually large and the memory size is limited, only a part of the accumulator output bits is connected to the ROM. For example, if the 14 most significant bits (MSBs) of the accumulator are connected to the ROM and a 12-bit output from the ROM is required to drive a 12-bit DAC, the size of the required memory is $2^{14} \cdot 12$, which is equivalent to 196,608 bits of memory and is already quite a large ROM. Since not all the accumulator bits are connected to the ROM, a level of truncation has to be introduced. The digital output bits of the ROM, which converted the phase information to amplitude, are then connected to the DAC and LPF that generate the analog sine wave. The LPF rejects all aliasing frequencies and is therefore theoretically limited to the Nyquist frequency (half the sampling rate $f_{clk}$). It is sometimes referred to as the anti-aliasing filter.

One of the most important specifications to direct digital synthesis (DDS) is that of spectral purity. Spurious discrete spectrum components (DSCs) are mainly caused by

- the truncation of the instantaneous phase in the accumulator circuitry (ACC), which is done to match the address wordlength of the ROM,

- amplitude quantization,

- data compression implemented in the ROM, which is done to maximize the output frequency by minimizing the size of the ROM, and

- imperfections in the DAC such as nonlinearities, glitches which occur due to differences in the on/off switching, switching time disparities between different bits as well as limited settling time.

Amplitude quantization errors cause harmonically related spurs, whereas phase truncation produces spurs around the desired output frequency by a phase modulation. The aforementioned numerical distortions and algorithmic nonlinearities, which do exist due to finite-wordlength effects as well as due to non-idealities of integrated digital-to-analog converters (DACs) are the major sources of spectral impurity. Knowing the exact location and power level of spurs is therefore a good starting point for the design of a DDFS. Analytical results (particularly for amplitude quantization) are rather complicated as spurs originating from this type of signal error vary rather irregularly with tuning. Therefore, interpreting the parameter dependence of these spurs is not easy.

Amplitude quantization operations such as rounding operations - especially minimum distance (or nearest neighbor) mapping - have odd symmetry and generate odd harmonics only, the level of which oscillates violently and their dependence on the signal amplitude and resolution is very complicated. Moreover, because of aliasing effects, some harmonics can fold back into the desired band and possibly overlap. These overlapped spectral lines may constructively or destructively contribute to the level of the resulting component depending on their actual phase and amplitude values.

In comparison with analog, PLL-based frequency synthesis approaches, a DDFS provides many significant advantages: Fast settling time, sub-Hertz frequency resolution, continuous-phase switching response as well as low phase noise are features which can easily be achieved by means of DDS systems. Aside from fast switching speed and high resolution, a DDFS offers high accuracy, reliability and reproducibility of digital designs, and a comparatively high level of integration. Additionally, since the signal is manipulated digitally, it is easy to modulate the signal, to achieve an accuracy that can not be attained by means of analog techniques and to conveniently interface with computing machines that control the frequency synthesizer. Whereas earlier DDF synthesizers were limited to produce narrow bands of closely spaced frequencies due to limitations of digital logic and DAC technologies, recent advantages in integrated circuit (IC) technologies have brought about remarkable progress in this area. By programming the DDFS, adaptive channel bandwidths, modulation format, and frequency hopping can easily be achieved. Such a DDFS can advantageously be applied in the modulator or demodulator part of a wireless communication device.

However, applying a DDFS usually involves a series of drawbacks. One of the main drawbacks is that a DDFS is a power-consuming device which occupies a large chip area. Typically, a DDFS has a high frequency changing speed, but at the same time it requires high supply power and features spurious spectrum performance. In this connection, it should be noted that the power level of these spurious harmonics can achieve values between -70 and -80 dBc. A further limitation, due to Nyquist's sampling theorem, requires the maximum output frequency $f_{DDS}$ to be less than half the clock frequency $f_{clk}$. Synthesizer design is thus a trade-off between having a large, spurious-free dynamic range and having a high speed, the former requiring reduced phase truncation, gained at the expense of a large, slow ROM. The digital parts of the circuit are generally designed with a resolution small enough that the spurious-free dynamic range is determined by the properties of the DAC.

For the purpose of reducing the level of spurious harmonics, noise-shaping techniques are usually applied, which decorrelate the truncated phase values, thereby spreading narrowband spurs at frequencies close to the desired frequency across the entire frequency band as wideband noise. For analog output signals whose frequencies $f_{DDS}$ are low with respect to the clockrate $f_{clk}$, thereby fulfilling Nyquist's sampling theorem

$$ f_{clk} \overset{!}{\geq} M \cdot f_{DDS} \quad \Leftrightarrow \quad T \overset{!}{\leq} \frac{1}{M \cdot f_{DDS}} \quad \text{with } M := 2, $$

a DDFS acts as an oversampling system ($M > 2$), and the noise shaper shifts the spectrum of the phase truncation noise to higher frequencies, thereby improving the spectral purity of the output over the frequency range of interest. However, it has been shown by simulation and measurement that there are frequencies for which noise shaping brings no advantage or even deteriorates performance and that noise-shaping techniques can not generally be used to achieve a spurious-free dynamic range in all cases.

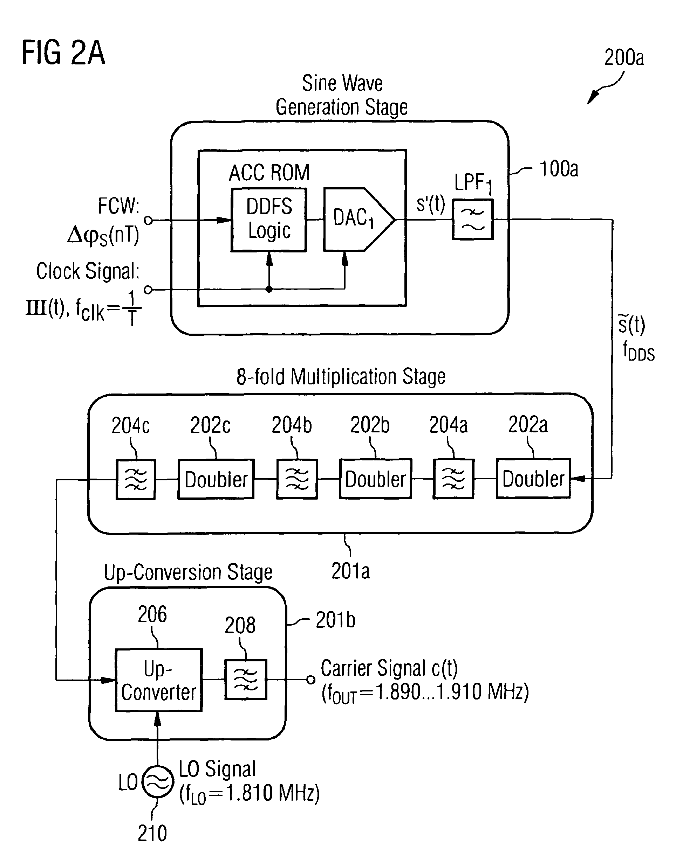

Since the frequency range covered by a DDFS unit is limited, its usage in cellular communication systems is only possible in combination with frequency up-conversion means using a single-sideband mixer (SSB) and a local oscillator (LO) controlled by a phase-locked loop (PLL) circuitry as shown in Fig. 2a. This principle of frequency generation is well-known in literature. Fig. 2a shows a conventional frequency synthesizer architecture 200a according to the state of the art with an up-conversion structure. The frequency synthesizer 200a consists of a DDS stage 100a, which is followed by an eight-fold multiplication and band-pass filtering stage 201a and an up-conversion and filtering stage 201b.

Sine-output DDF synthesizers based on the architecture as shown in Fig. 1a differ mostly in their implementation of the phase-to-sine amplitude converter block. Since this block is normally the slowest and most power-consuming component, it has been the target of much research effort in the past 30 years. The simplest approach for the realization of the phase-to-sine amplitude converter is to use a read-only memory (ROM). However, its size grows exponentially with the size $P'$ of the phase accumulator (ACC). Since one normally desires a large wordlength to achieve fine frequency tuning, several techniques have been devised to limit the ROM size $P'$ while maintaining adequate performance. Truncating the phase accumulator output $\varphi_s(nT)$ is a common method for reducing the size $P'$ of the employed ROM, although it introduces spurious harmonics. Still, this approach is almost universally adopted because of fine frequency resolution requirements requiring a very large value for $P'$. Various angular decomposition methods have been proposed to further reduce memory requirements with LUT-based methods. These methods normally consist of splitting the ROM into a number of smaller units, each addressed by a portion of the truncated phase accumulator output. Data retrieved from each sub-ROM is added to yield a sinusoid approximation.

In order to reduce the ROM size further, researchers have proposed making an initial approximation of the sine amplitude from the value of the phase angle and to use the ROM or a combination of different ROMs to store correction values. These are often referred to as amplitude compression techniques. Used in combination with ROM segmentation, an effective ROM size compression ratio of 37:1 has been attained. The ROM size can be further reduced by increasing the amount of calculations performed to obtain a sine approximation. Several researchers have proposed approaches using piecewise continuous polynomials to approximate the first quadrant of the sine function. These have been based either on trigonometric approximations, on a Taylor-series expansion, on a simplified fourth-degree polynomial, on fourth-degree Chebyshev polynomials, or linear segments of unequal lengths. All these approaches are based on the premise that the amplitude error on the sinusoid approximation for any phase angle must be reduced to what would be achievable with a ROM lookup table.

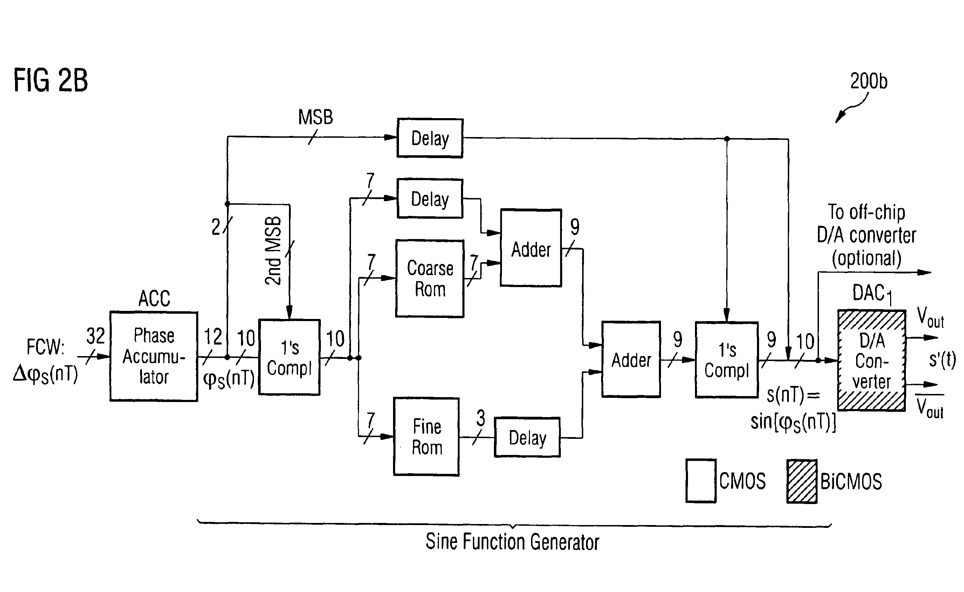

A system architecture for a conventional sine ROM compression according to the state of the art is shown in Fig. 2b. Thereby, the two most significant phase bits of the signal at the output port of the accumulator are used to decode the quadrant, while the remaining 10 bits are used to address different one-quadrant sine ROMs. A so-called 'coarse' ROM provides low-resolution phase samples, and a 'fine' ROM gives additional phase resolution by interpolating between low-resolution phase samples. In Fig. 2b the size of the upper memory, whose access time is the most critical, is reduced by a sine difference algorithm. This saves 2 bits of amplitude in the storage of the sine function, but an extra adder is required at the coarse ROM output. A Fast Fourier Transform (FFT) of the compressed ROM content then yields a digital output spectral purity of -74 dBc in the worst case.

BRIEF DESCRIPTION OF THE STATE OF THE ART

The invention described in the European patent application EP 0 452 031 A2 refers to a circuit for generating an analog signal by means of a digital-to-analog conversion, such as a direct digital frequency synthesizer (DDFS) of the type including a frequency number generator, a phase accumulator (ACC), a function generator in form of a lookup table (LUT) holding discrete sine values, a random number generator (RNG) as well as two digital-to-analog-converters (DACs). The object of this circuitry is to perform a randomization procedure that reduces spurious harmonics and the power level of glitches in the output signal spectrum of the DDFS. Thereby, a digital-to-analog converter (DAC) mitigates the production of analog signal errors, manifested as spurious frequency signals, by modifying the digital number representing each function value with a digital random number added or subtracted by an arithmetic logical unit (ALU). The randomly modified function number and digital random number are then converted to analog values by means of a first and a second digital-to-analog converter ($DAC_1$ and $DAC_2$), respectively. After that, these analog values are combined to remove the effects of randomizing. As conversion in the first digital-to-analog converter is spread randomly over all DAC levels, any conversion errors associated with any DAC steps which by repeated use would be manifested as spurious frequency signals are decorrelated to broadband noise. A similar circuitry generating a sawtooth signal can be deployed for improving phase control linearity in a phase-locked loop (PLL) frequency synthesizer. However, as the DDFS structure presented in EP 0 452 031 A2 does not realize the odd symmetry of the obtained glitches, the output signal spectrum of the DDFS contains spurious components representing the even harmonics of the synthesized frequency. The main drawback of this patent application is thus the relatively bad quality of the output signal spectrum.

In the US patent 6,005,419, a DDFS circuit and method for reducing the harmonic content of a synthesized output signal is disclosed. The DDFS generates first and second address signals driving a first and a second sine lookup read-only memory (sine ROM) circuit. Said sine ROMs respectively generate a first and a second digital sine wave signal which are offset in phase from each other by $\pi$ radians. These digital sine wave signals are then submitted to a digital-to-analog conversion and combined by means of a subtractor circuit. As a result of the phase relationship between the first and second analog sine wave signal, the first harmonic components of these signals are emphasized by said subtraction, whereas the second harmonic components of these signals are simultaneously de-emphasized. The proposed solution thus utilizes the odd symmetry scheme of the resultant signal spectrum. However, it does not apply any randomization procedure. Consequently, the output signal spectrum still contains the odd-numbered harmonics of the synthesized frequency.

A randomization method which can advantageously be used for reducing quantization errors and an apparatus for reducing spurious output noise in digital frequency synthesizers employing sine amplitude converters and digital-to-analog converters (DACs) to generate analog waveforms from synthesized sine amplitude sample data are disclosed in the US patent 4,901,265. Random or pseudo-random numbers having a value equal to or less than plus or minus one half of a minimum quantization step or value change for the sine amplitude sample data are generated and added to the sine amplitude data with the resultant sum being transferred to the DAC. In one embodiment of this invention, a summation circuit is connected between an output port of the sine function converter and an input port of the digital-to-analog converter. It comprises a second input port connected to a pseudo-random number generator (RNG) which provides pseudo-random numbers varying in value over a range of $\pm 0{,}5^{n+1}$ times a least significant bit (LSB) value of a corresponding DAC input data value, where $n$ is an integer value greater than or equal to one.

The US patent 5,864,492 describes the generation of saw-forming signals which are needed for generating a digital frequency signal. The disclosed DDFS includes a phase accumulator (ACC) for repeatedly accumulating a phase value to generate samples of a digital sawtooth signal and a lookup table (LUT) holding digital sample values which are used for converting the digital sawtooth signal to a digital waveshape signal. In order to reduce the effect of the quantization of the digital samples, the synthesizer also includes a randomizer for applying a randomizing factor to output digital samples in order to form the digital frequency signal. The randomizer includes a random number generator (RNG) connected to receive $P$ bits of each digital sample for generating at least one randomizing bit and a summer for summing the remaining *N* bits of the digital sample and the at least one randomizing bit to generate a digital waveshape sample of the digital frequency signal.

The invention described in the PCT application WO 01/18637 A1 pertains to an improvement of the spectral characteristics of DDFS output signals, especially in the range of a desired carrier frequency, by using a random valve sequence which is generated by a random valve generator, modified in a filter or mapping unit and summed before or after the accumulator circuitry (ACC) of the DDFS.

The invention disclosed in the US patent 4,410,954 describes a dual-level frequency synthesizer for synthesizing a selected frequency or a set of preselected frequencies. Thereby, a selected phase increment is fed at a clockrate to an adder and accumulating register in mutual cooperation as a digital integrator, the resultant period overflow of the register corresponding to the selected frequency of interest. An improvement is provided for reducing discrete spectral spurs in the spectral output of the synthesizer by means of preselectively randomly jittering the input to (or output of) the register, whereby the average periodicity of the register overflow for a selected frequency is not affected.

A DDFS including a counter circuitry for receiving input signal pulses and for providing a corresponding output signal after receiving a number of input signal pulses is described in the US patent 4,815,018. This number is selected based on the state of a control signal. The invention includes a circuit for generating a pseudo-random sequence of numbers and a comparator circuit for comparing the respective pseudo-random number with a predetermined number and providing the corresponding control signal in response thereto.

In the US patent 4,835,721 a frequency synthesizer for use by an operator or other means for continuously generating an output noise signal is disclosed. The frequency synthesizer comprises a digital means for directly synthesizing random noise having controlled spectral amplitudes. The synthesized random noise is characterized by a series of digital composite frequency synthesizer output noise signal sample values. The digital means comprises a means for providing and periodically changing a series of sets of shifted segment frequency values, each set of shifted frequency values having a controlled series of random frequency values. Each frequency value is a random digital number selected to be within a range corresponding to a segment frequency band characterizing a shifted segment frequency value. A plurality of digital oscillators is included, each oscillator having a corresponding segment frequency band. Each oscillator output is a series of digital values that sequentially characterizes a sinusoid having a frequency that signals the shift segment frequency of the respective frequency band.

Another digital frequency synthesizer architecture is described in the US patent 4,933,890. Thereby, the edge timing of a clock-synthesized numerically controlled oscillator waveform of a desired frequency is corrected to coincide more precisely with that of an ideal waveform of the desired frequency by providing an NCO output signal to a controllable delay line. It determines from the NCO output signal an offset time of the NCO clock signal from that of the ideal waveform and controls the delay of the delay line so that the output signal has an edge substantially coincident with the ideal waveform. By using delays which are obtained as small fractions of a system clock interval, direct digital synthesis of frequencies near the clock frequency is achieved. Preferably, the delay is performed with a tapped delay line, which may be implemented as a chain of transistors in a monolithic device. In a preferred embodiment of this invention, remaining periodic phase variations are further suppressed by randomizing the tap selection sufficiently in order to suppress sideband spurs. This can be accomplished by selecting two or more adjacent tap delays and using a random sequence generator to control an early or late tap selection switch. Besides, fabrication of a gigahertz range DDFS is described.

In the US patent 4,951,237 an accumulator circuit of a DDFS is disclosed wherein a selected number of low-order accumulator bits are dithered by a pseudo-random number generator in order to introduce flat frequency deviation density to suppress spurious harmonics close to the carrier frequency, which are caused by phase errors. The accumulator circuitry may advantageously be sectioned into a lower-order accumulator and a higher-order accumulator in a pipelined combination with a sine approximation output circuitry in order to construct a DDS circuit wherein such spur suppression is achieved without decreasing system throughput.

A method for suppressing spurious frequency components in a DDFS and a proposal for using a sample-and-hold block to reduce the level of glitches is described in the US patent 5,073,869. Therein, a DDFS generates an analog waveform of a predetermined frequency from accumulated digital frequency words which, when accumulated, represent the phase of a sine wave of the predetermined frequency. The synthesizer includes a phase accumulator (ACC), a 4-bit nonlinear digital-to-analog converter (DAC), and a sample-and-hold circuit. The ACC includes a 4-bit coarse-component accumulator for accumulating coarse phase components of the digital frequency words and a fine-component accumulator for accumulating fine phase components of the digital frequency words. The phase accumulator increments said coarse-component accumulator in response to accumulated fine phase components exceeding a predetermined value. The 4-bit nonlinear DAC converts the four bits accumulated in the coarse-component accumulator into an analog waveform of the predetermined frequency. The ACC suppresses the generation of spurious frequency components in the analog waveform by randomly dithering the rate at which the coarse-component accumulator is incremented by the phase accumulator. The sample-and-hold circuit is coupled to the output of the nonlinear DAC for mitigating any glitch errors induced in the nonlinear DAC by sampling the analog waveforms at those times when glitch-induced errors are not present. The drawbacks of this method are practical difficulties in realizing sample-and-hold circuitries: Typically, sample-and-hold blocks use switches and amplifiers, which should work from zero to hundreds of megahertz and have a settling time below 2 ns. The switch impedance in open states should be below 2 $\Omega$ and the current in close states should be below 1 pA. Additionally, by synthesizing higher frequencies, the time interval between two samples could become less than the settling time, and then the sample-and-hold circuitry would not work.

An apparatus and method for spurious signal reduction in direct digital frequency synthesizers is disclosed in the US patent 5,521,533. Therein, a synthesizer based upon DDFS techniques of a simplistic design and minimized spurious signal levels is used. The output signals of two frequency-hopped direct digital frequency synthesizers are combined with the resultant signal having a greatly suppressed spurious signal level due to the channel spacing variation of the spur. Alternative embodiments concern the number and functional location of digital-to-analog converters (DACs), varying the clock signal, and the use of high-pass filters (HPFs). The main drawback of this invention is the increased power consumption due to the use of memory units.

The invention described in the US patent 5,761,101 relates to a device for reducing unwanted frequency components in digital frequency generation. It comprises an accumulator circuit for generating output signals depending on an input code corresponding to a desired frequency, said accumulator circuit being connected to at least one memory unit which comprises codes corresponding to different waveshapes, a generator for generating a random code, and a digital-to-analog converter (DAC) for generating analog waveshapes. The invention is characterized in that it comprises modulation means which are used for generating a first modulated signal constituting the sum of the input code and the random code and for generating a second modulated signal constituting the difference between the input code and the random code and a calculation unit for regenerating a code corresponding to said input code. The invention thereby provides a significant reduction of unwanted spurious frequency components. Like in US 5,521,533, the main drawback of this invention is the increased power consumption due to the use of memory units.

A process and a corresponding device for the generation of a random signal and a digital-to-analog conversion system using this signal is disclosed in the US patent 6,337,643 B1. The process includes a first noise generation step, a second noise filtering step to obtain a signal with a predetermined spectral envelope, a third step in which a nonlinear function is applied to said signal in order to obtain a further signal similar to a predetermined amplitude histogram, and a fourth step in which a pulse response filtering is applied to the signal to correct its spectral envelope and obtain an output signal with a predetermined spectral envelope. The pulse response is the inverse Fourier transform of a frequency function obtained by dividing the function by the modulus of the Fourier transform of the signal. Such a process, device, and system can advantageously be applied to a DDFS, e.g. in radar or instrumentation applications. However, this architecture can not be used for a randomization procedure reducing glitches as it increases the noise power level at the frequency synthesizer's output port.

OBJECT OF THE UNDERLYING INVENTION

In view of the state of the art mentioned above, it is the object of the underlying invention to provide an improved frequency synthesizing unit for reducing artefacts (f.e spurious harmonics, "glitches") in the synthesizer's output signal spectrum caused f.e. by time quantization errors.

The aforementioned object is achieved by means of the features in the independent patent claims. Advantageous features are defined in the subordinate patent claims.

SUMMARY OF THE INVENTION

The underlying invention generally relates to the field of Direct Digital Frequency Synthesizer (DDFS) architectures used for generating an oscillator signal $\tilde{s}(t)$ with an approximately sinusoidal waveshape, which can advantageously be applied to wireless RF transceivers in a cellular communication system based on a fast frequency-hopped spread spectrum (FHSS) technology. The invention particularly refers to a method for the reduction of spurious harmonics, voltage and/or current glitches in the synthesizer's noise power density spectrum $\tilde{\Phi}_{ee}(kf)$ caused by phase truncation, amplitude quantization errors and/or time quantization errors, which introduce jitter into the output waveform $\tilde{s}(t)$. Discrete $P$-bit phase difference values $\Delta\varphi_s(nT)$ serving as frequency control words (FCWs) are repeatedly accumulated to generate P-bit samples of a digital sawtooth signal $\varphi_s(nT)$ with a predefined time period $N{\cdot}T$, which are then submitted to a phase-to-sine-amplitude conversion which converts the obtained discrete phase input values $\varphi_s(nT)$ into a set of discrete sine amplitude sample values $s(nT)$. After that, these discrete sine amplitude sample values $s(nT)$ are converted into an approximation of a quantized analog sine wave $a_1{'}(t)$.

According to one embodiment of the underlying invention, spurious harmonics (DSCs) are spread over the entire signal spectrum by adding a $P$-bit number word representation of a random number $r(nT)$ to the obtained sine amplitude sample values $s(nT)$. Thereby, the periodical structure of glitches, phase truncation errors and quantization errors $\tilde{e}(nT)$ of the approximated sine wave $\tilde{s}(t)$ is destroyed and its spurious discrete noise power density spectrum

$\tilde{\Phi}_{ee}(kf)$ caused by the error signal $\tilde{e}(nT)$ is transformed into a continuous noise power density spectrum $\check{\Phi}_{ee}$ $(f)$ having an approximately constant spectral power density No as well as the same total noise power $P_e$ as the original noise power density spectrum $\tilde{\Phi}_{ee}(kf)$. The additive noise is then compensated by subtracting a digital-to-analog converted representation of said random number $r(nT)$ from the quantized analog sine wave approximation $a_1'(t)$ at the analog output port of the direct digital frequency synthesizing unit (DDFS).

BRIEF DESCRIPTION OF THE DRAWINGS

Advantageous features, aspects, and advantages of the invention will become evident from the following description, the appended claims, and the accompanying drawings. Thereby,

Fig. 1a      depicts a schematic block diagram of a conventional direct digital frequency synthesizing unit (DDFS) according to the state of the art,

Fig. 1b      depicts a block diagram showing the internal structure of a conventional phase accumulator (ACC) circuitry according to the state of the art,

Fig. 1c      depicts a block diagram showing a conventional PLL frequency synthesizing unit (FSU) according to the state of the art,

Fig. 1d      shows a diagram illustrating the generation of an analog sawtooth signal $(\varphi_s(nT))$ with a predefined time period $(N \cdot T)$ whose slope is direct proportional to the frequency of the sine wave to be generated,

Fig. 1e      presents a diagram showing the output signals $(\varphi_s(nT), s(nT), s'(t),$ and $\tilde{s}(t))$ of the phase accumulator (ACC), the phase-to-amplitude converter (Sine ROM), the digital-to-analog converter (DAC$_1$), and the low-pass filter (LPF$_1$), respectively,

Fig. 2a      presents a schematic block diagram showing an RF transmitting unit of a wireless communication device which comprises a conventional digital frequency synthesizing unit (DDFS) followed by an eight-fold multiplication and filtering stage and a signal up-conversion stage,

Fig. 2b      presents a schematic block diagram showing the phase accumulator (ACC) and sine function generator (ROM) of a conventional digital frequency synthesizing unit (DDFS) with a reduced ROM size, where only approximation error data must be stored in the DDS ROM,

Fig. 3      presents a diagram showing the spurious output signal spectrum $(\tilde{S}(f))$ of a conventional digital frequency synthesizing unit 100a (DDFS) according to the state of the art, and

Fig. 4      shows a PLL frequency synthesizing unit used in a mobile RF transmitter or RF receiver of a wireless communication device.

DETAILED DESCRIPTION OF THE UNDERLYING INVENTION

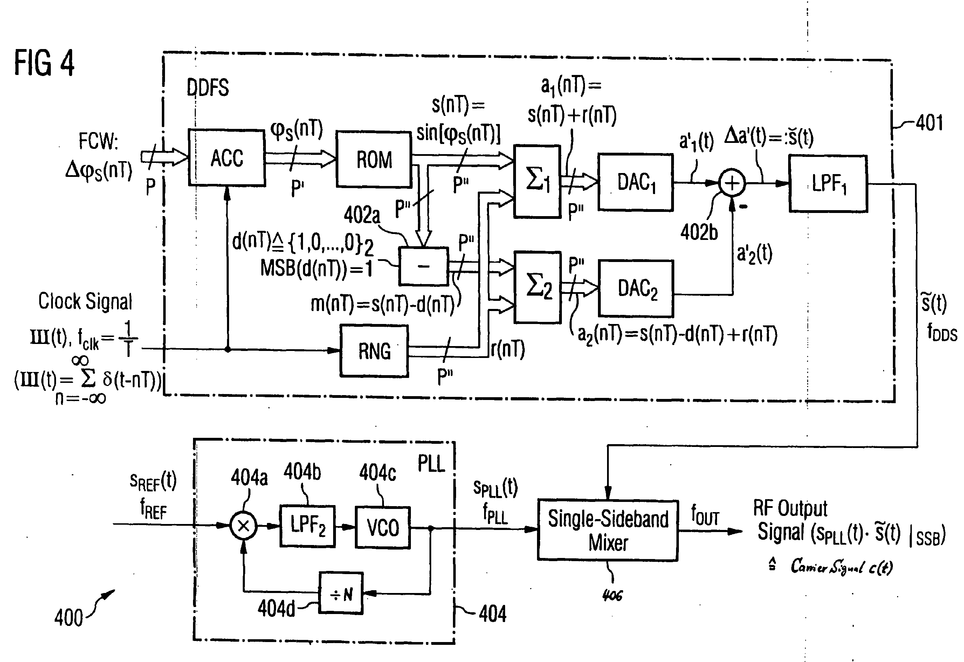

In the following, one embodiment of the underlying invention as depicted in Fig. 4 shall be explained in detail. The meaning of the symbols designated with reference signs in Figs. 1a to 4 can be taken from an annexed table.

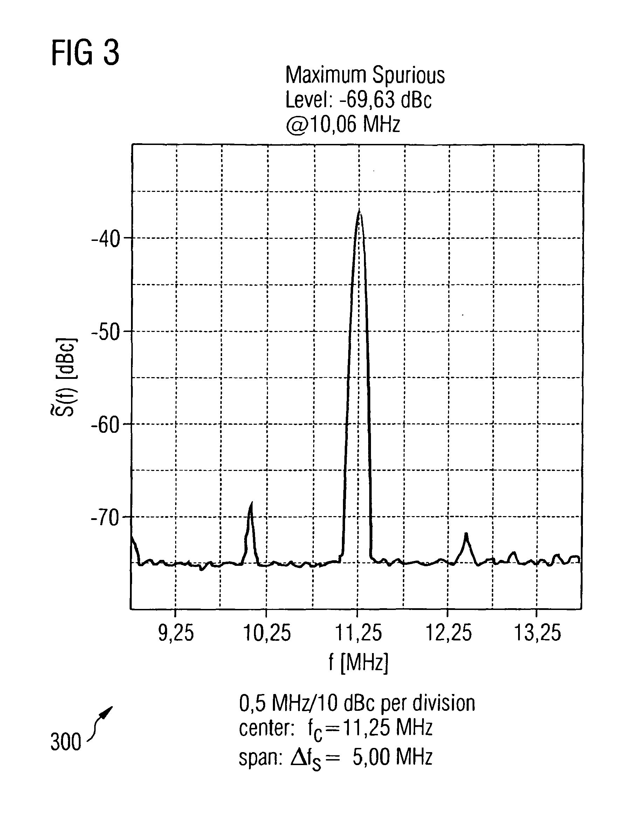

As can be taken from Fig. 3, the maximum spurious DCS level in the output signal spectrum $\tilde{S}(f)$ of the DDFS is -69.63 dBc. To reduce the spurious DSC level produced in the digital-to-analog converter DAC$_1$, a randomization technique according to one embodiment of the present invention shall now be proposed. This method destroys the periodical structure of the signal error, thus transforming the spurious discrete noise power density spectrum $\tilde{\Phi}_{ee}(kf)$

into a wideband continuous noise power density spectrum $\check{\Phi}_{ee}$ $(f)$. Thereby, the total noise power $P_e$ remains the same, but the levels of discrete components are reduced due to a "DSC smearing". According to the above-described working principle, an enhanced direct digital frequency synthesizers structure as depicted in Fig. 4 is proposed. The proposed frequency synthesizer differs from the known DDFS unit according to the state of the art depicted in Fig. 1a as follows: It comprises an additional random number generator (RNG), two digital adders ($\Sigma_1$, $\Sigma_2$), two digital analog converters

(DAC$_1$, DAC$_2$) as well as analog and digital subtracting means 402a+b.

The advantage of the proposed frequency synthesizer compared to a conventional frequency synthesizer as shown in Fig. 2a is the better quality of the output signal spectrum, which can be achieved by applying the aforementioned randomization algorithm. It reduces the level of voltage and current pulses (glitches) occurring at the output port of the digital-to-analog converter (DAC$_1$), which are caused by time differences in the on/off switching of different bits inside said DAC. To randomize these glitches, digital random numbers are added to the digital input values of DAC$_1$. Consequently, glitches are produced with random principle.

To compensate additive noise caused by said random numbers, the proposed DDFS structure further comprises a digital subtractor realized as a two's complement adder 402a, a second digital adder ($\Sigma_2$), a second digital-to-analog converter (DAC$_2$), and an analog subtractor 402b. The proposed DDFS structure compensates the additive noise and simultaneously produces and output spectrum featuring odd symmetry of the obtained glitches. This allows to completely remove even-numbered spurious harmonics (DSCs) with low level.

Theoretically, it is possible to fully transfer the total noise power $P_e$ of the discrete spurious harmonics into a continuous noise power density spectrum $\check{\Phi}_{ee}$ (f). However, this is only valid for the case of an unlimited randomization period. In frequency-hopped spread spectrum (FHSS) systems the randomization period is limited in time when frequency is not changed. As a consequence of this, some odd-numbered spurious harmonics having a low power level will still be present in the obtained output signal spectrum $\tilde{S}(f)$ of the DDFS.

In accordance with one embodiment of the present invention, the additive noise is compensated by subtracting a digital-to-analog converted representation $a_2(t)$ of a pseudo-random signal $a_2(nT)$ containing information about the symmetrical location and power level of the harmonically related spurs (DSCs) from the quantized analog sine wave approximation $a_1'(t)$ at the analog output port of the direct digital frequency synthesizing unit (DDFS). This has the effect that even-numbered spurious harmonics (DSCs) in the output signal spectrum can be reduced significantly. Thereby, said pseudo-random signal $a_2(nT)$ is generated by setting (S6) the most significant bit (MSB) of a $P$''-bit number word representing said sine amplitude sample values $s(nT)$ to '0' and adding (S7) the $P$''-bit number word representation of the random number $r(nT)$ to the resultant $P$''-bit number word

$$m(nT) := s(nT) - a(nT) \; \forall n$$

of said zero-setting operation. This is done by adding a $P$''-bit number word representing the sine amplitude sample values $s(nT)$ to the two's complement of a $P$''-bit number word $d(nT)$ whose most significant bit (MSB) is set to '1' and the remaining bits are set to '0' and adding the $P$''-bit number word representation of the random number $r(nT)$ to the $P$''-bit number word representing the obtained difference signal $m(nT)$. The obtained discrete sample values

$$a_2(nT) := m(nT) + r(nT) \; \forall \; n$$

are then submitted to a digital-to-analog conversion, before the resultant analog output signal $a_2'(t)$ is subtracted from the quantized analog sine wave approximation $a_1'(t)$.

Aliasing harmonics in the output signal spectrum $\check{S}(f)$ of the direct digital frequency synthesizing unit (DDFS) can be suppressed by means of a low-pass filter (LPF$_1$), which furthermore smoothes the shape of the resultant analog sine wave approximation $\check{s}(t)$.

In accordance with a further embodiment of the present invention, the output signal $s(t)$ of the direct digital frequency synthesizing unit (DDFS) is used for a direct up-conversion (S11) of the output signal $S_{PLL}(t)$ of a phase-locked loop (PLL)-controlled oscillator circuit by means of a single-sideband (SSB) mixer (406), the analog RF signal $S_{PLL}(t) \cdot \tilde{s}(t) \mid_{SSB}$ at the output port of said single-sideband mixer (406) serving as a carrier signal $c(t)$ for an up-conversion of a baseband signal to be transmitted to the passband or a down-conversion of a received modulated RF signal from the passband to the baseband, respectively.

The present invention also refers to a direct digital frequency synthesizing unit (DDFS) of an electronic device used for generating a quantized analog sine wave $a_1'(t)$ with an approximately sinusoidal waveshape, which is specially designed for performing a method as described above. It comprises a phase accumulator (ACC) with at least one $P$'-bit register (104) and a digital summation element (102) as shown in Fig. 1b, that serves as a discrete integrator for repeatedly accumulating $P$-bit number words representing discrete phase increment values $\Delta\varphi_s(nT)$, which serve as frequency control words (FCW), to generate $P'$-bit samples of a digital sawtooth signal $\varphi_s(nT)$ with a predefined time period $N \cdot T$. Besides, said DDFS comprises a read-only memory (ROM) serving as a lookup table (LUT) for a phase-to-sine-amplitude conversion of discrete phase input values $\varphi_s(nT)$ supplied by the phase accumulator (ACC) into a set of discrete sine amplitude sample values $s(nT)$, a random number generator (RNG) generating $P''$-bit number words representing digitally encoded pseudo-random numbers $r(nT)$, digital summation means ($\Sigma_1$) for adding an obtained $P''$-bit number word representation of a random number $r(nT)$ to the $P''$-bit number word representing the discrete output signal $s(nT)$ of the read-only memory (ROM), which yields a $P''$-bit number word representing the discrete signal

$$a_1(nT) := s(nT) + r(nT) \; \forall n,$$

and at least one digital-to-analog converter (DAC$_1$) for converting the sine amplitude sample values $s(nT)$ into a quantized approximation of an analog sine wave $a_1'(t)$.

In addition, low-pass filtering means (LPF$_1$) can be employed for suppressing aliasing harmonics in the output signal spectrum ($\breve{S}(f)$) of the DDFS, thereby smoothing the shape of the resultant analog sine wave ($\breve{s}(t)$) approximation at its output port.

According to one embodiment of the present invention, said DDFS comprises a bit-serial two's complement adder (402a) executing an addition of the two's complement of a predefined $P''$-bit number control word $d(nT)$ whose most significant bit (MSB) is set to '1' and the other bits are set to '0', to the $P''$-bit number word representing the sine amplitude sample values $s(nT)$ at the output ports of the read-only memory (ROM). A further digital summation element ($\Sigma_2$) serves to add a $P''$-bit number word representing a random number $r(nT)$ to a $P''$-bit number word representing the obtained difference value $m(nT)$, which yields a $P''$-bit number word representing the discrete signal $a_2(nT)$. It finally comprises a further digital-to-analog converter (DAC$_2$) for converting the discrete sample values $a_2(nT)$ at the output ports of the second digital summation element ($\Sigma_2$) into a quantized analog signal ($a_2'(t)$) and an analog subtracting element (402b) used for calculating the analog difference signal

$$\Delta a'(t) := a_1'(t) - a_2'(t)$$

of the quantized analog signals $a_1'(t)$ and $a_2'(t)$ obtained at the output ports of the digital-to-analog converters (DAC$_1$, DAC$_2$), which serves as an approximation for the sine wave $s(t)$ to be generated.

A still further embodiment of the present invention respectively pertains to an RF transmitting unit and an RF receiving unit of a wireless communication device which comprises a direct digital frequency synthesizing unit (DDFS) executing a method as described above. Both the wireless RF transmitter and the wireless RF receiver are equipped with a single-sideband (SSB) mixer for combining the output signal $s(t)$ of the DDFS with the output signal $s_{PLL}(t)$ of a phase-locked loop (PLL)-controlled oscillator circuit. The analog RF signal $s_{PLL}(t) \cdot \breve{s}(t) \mid_{SSB}$ at the output port of said single-sideband mixer (406) serves a carrier signal $c(t)$ for an up-conversion of a baseband signal to be transmitted to the passband or a down-conversion of a received modulated RF signal from the passband to the baseband, respectively.

Table: Depicted Features and Their Corresponding Reference Signs

| No. | Technical Feature or System Component |
|---|---|
| 100a | schematic block diagram of a conventional direct digital frequency synthesizing unit (DDFS) according to the state of the art |
| 100b | block diagram showing the internal structure of a conventional phase accumulator (ACC) circuitry according to the state of the art |
| 100c | block diagram showing a conventional PLL frequency synthesizing unit (FSU) according to the state of the art |
| 100d | diagram illustrating the generation of an analog sawtooth signal ($\varphi_s(nT)$) with a predefined time period $(N \cdot T)$ whose slope is direct proportional to the frequency of the sine wave to be generated |

(continued)

| No. | Technical Feature or System Component |
|---|---|
| 100e | diagram showing the output signals ($\varphi_s(nT)$, $s(nT)$, $s'(t)$, and $\widetilde{s}(t)$) of the phase accumulator (ACC), the phase-to-amplitude converter (Sine ROM), the digital-to-analog converter ($DAC_1$), and the low-pass filter ($LPF_1$), respectively |
| 100e1 | diagram showing the output signal ($\varphi_s(nT)$ of the phase accumulator (ACC) |
| 100e2 | diagram showing the output signal ($s(nT)$) of the phase-to-amplitude converter (Sine ROM) |
| 100e3 | diagram showing the output signal ($s'(t)$) of the digital-to-analog converter ($DAC_1$) |
| 100e4 | diagram showing the output signal ($\widetilde{s}(t)$) of the low-pass filter ($LPF_1$) |
| 102 | digital summation element of the phase accumulator (ACC) |
| 104 | *P'*-bit register of the phase accumulator (ACC) |
| 106 | phase-locked loop (PLL) circuitry of a PLL frequency synthesizing unit 100c used in a mobile RF transmitter or RF receiver of a wireless communication device which controls the oscillating frequency of a multi-phase voltage-controlled crystal oscillator (VCXO) and stabilizes the transmission frequency of a signal to be transmitted or the carrier frequency provided by the local oscillator (LO) of a mobile RF transmitter or RF receiver, respectively |
| 106a | analog multiplication element of the phase-locked loop (PLL) circuitry 106 |
| 106b | low-pass filter ($LPF_2$) of the phase-locked loop (PLL) circuitry 106 |
| 106c | voltage-controlled oscillator (VCO) of the phase-locked loop (PLL) circuitry 106 |
| 106d | frequency divider of the phase-locked loop (PLL) circuitry 106 |
| 108 | single-sideband (SSB) mixer of the PLL frequency synthesizing unit 100c, which is used to suppress image frequencies of unwanted sidebands of the modulated RF signal x(t) to be transmitted |
| 200a | schematic block diagram showing an RF transmitting unit of a wireless communication device which comprises a conventional digital frequency synthesizing unit 100a (DDFS) followed by an eight-fold multiplication and filtering stage 201a and a signal up-conversion stage 201b |
| 200b | schematic block diagram showing the phase accumulator (ACC) and sine function generator (ROM) of a conventional digital frequency synthesizing unit 100a (DDFS) with a reduced ROM size, where only approximation error data must be stored in the DDS ROM |
| 201a | eight-fold multiplication stage of the wireless RF transmitting unit 200a |
| 201b | up-conversion stage of the wireless RF transmitting unit 200a |
| 202a | first frequency doubler of the 8-fold multiplication stage 201 a |
| 202b | second frequency doubler of the 8-fold multiplication stage 201a |
| 202c | third frequency doubler of the 8-fold multiplication stage 201 a |
| 204a | first band-pass filter of the 8-fold multiplication stage 201 a |
| 204b | second band-pass filter of the 8-fold multiplication stage 201a |
| 204c | third band-pass filter of the 8-fold multiplication stage 201a |
| 206 | direct up-conversion mixer of the up-conversion stage 201b |
| 208 | band-pass filter of the up-conversion stage 201b |
| 210 | local oscillator (LO) of the wireless RF transmitting unit 200a |

(continued)

| No. | Technical Feature or System Component |
|---|---|
| 300 | diagram showing the spurious output signal spectrum $(\tilde{S}(f))$ of a conventional digital frequency synthesizing unit 100a (DDFS) according to the state of the art |
| 400 | PLL frequency synthesizing unit used in a mobile RF transmitter or RF receiver of a wireless communication device |
| 401 | schematic block diagram of a direct digital frequency synthesizing unit (DDFS) according to the underlying invention |
| 402a | digital subtracting element realized as a bit-serial two's complement adder executing an addition of the two's complement of a predefined $P''$-bit number control word $(d(nT))$ whose most significant bit (MSB) is set to '1' and the other bits are set to '0', to the $P''$-bit number word representing the discrete sine amplitude sample values $(s(nT))$ at the output ports of the read-only memory (Sine ROM), thereby yielding a $P''$-bit number word representing the discrete signal $m(nT) := s(nT) - d(nT)$ |
| 402b | analog subtracting element used for calculating the analog difference signal $\Delta a'(t)$ of the quantized analog signals $a_1'(t)$ and $a_2'(t)$ obtained at the output ports of the digital-to-analog converters $DAC_1$ and $DAC_2$ |
| 404 | phase-locked loop (PLL) circuitry of a PLL frequency synthesizing unit 400 used in a mobile RF transmitter or RF receiver of a wireless communication device which controls the oscillating frequency of a multi-phase voltage-controlled crystal oscillator (VCXO) and stabilizes the transmission frequency of a signal to be transmitted or the carrier frequency provided by the local oscillator (LO) of a mobile RF transmitter or RF receiver, respectively |
| 404a | analog multiplication element of the phase-locked loop (PLL) circuitry 404 |
| 404b | low-pass filter ($LPF_2$) of the phase-locked loop (PLL) circuitry 404 |
| 404c | voltage-controlled oscillator (VCO) of the phase-locked loop (PLL) circuitry 404 |
| 404d | frequency divider of the phase-locked loop (PLL) circuitry 404 |
| 406 | single-sideband (SSB) mixer of the PLL frequency synthesizing unit 400, which is used to suppress image frequencies of unwanted sidebands of the obtained carrier signal $c(t) := S_{PLL}(t) \cdot \tilde{s}(t)\mid_{SSB}$ |
| ACC | phase accumulator (ACC), also called digital frequency-to-phase converter (FPC) or digital phase wheel, comprising at least one $P'$-bit register and a digital summation element serving as a discrete integrator for repeatedly accumulating $P$-bit |
|  | number words representing discrete phase difference values $(\Delta\varphi_S(nT))$, that serves as a frequency control word (FCW), to generate $P'$-bit samples of a digital saw-tooth signal $(\varphi_S(nT))$ with a predefined time period |
| $DAC_1$ | first digital-to-analog converter with an integrated sample-and-hold unit for converting said discrete sample values $(a_1(nT))$ into a quantized approximation of an analog sine wave $(a_1'(t))$ |
| $DAC_2$ | second digital-to-analog converter with an integrated sample-and-hold unit for converting the discrete sample values $(a_2(nT))$ at the output ports of the second digital summation element $(\Sigma_2)$ into a quantized analog signal $(a_2'(t))$ |
| DDFS | Direct Digital Frequency (DDF) synthesizer, also known as Numerically Controlled Oscillator (NCO), which is used for generating a quantized analog sine wave ($s'(t)$ or $a_1'(t)$, respectively) with an approximately sinusoidal waveshape |

(continued)

| No. | Technical Feature or System Component |
|---|---|
| LPF$_1$ | low-pass filtering means for suppressing aliasing harmonics in the output signal spectrum ($\breve{S}$(f)) of the direct digital frequency synthesizing unit (DDFS) and smoothing the analog sine wave ($\breve{s}$(t) := Δa'(t)) obtained at the output port of the direct digital frequency synthesizing unit (DDFS) |
| LUT, Sine ROM | sine lookup table, also called digital phase-to-amplitude converter (PAC) or (sine) waveform mapping device, realized as a read-only memory (ROM) for a phase-to-sine-amplitude conversion of discrete phase input values ($\varphi_s(nT)$) supplied by the phase accumulator (ACC) into a set of sine amplitude sample values *(s(nT))* |
| RNG | random number generator generating *P''*-bit number words representing digitally encoded pseudo-random numbers |
| Σ$_1$ | first digital summation element for adding an obtained *P''*-bit number word representation of a pseudo-random number *(r(nT))* to the *P''*-bit number word representing the discrete output signal *(s(nT))* of the read-only memory (ROM), which yields a *P''*-bit number word representing the discrete signal $a_1(nT) := s(nT) + r(nT)$ |
| Σ$_2$ | second digital summation element for adding a *P''*-bit number word representing a random number *(r(nT))* to a *P''*-bit number word representing the obtained |
| | result value ($m(nT):=s(nT)-d(nT)$) of a digital subtraction of a *P''*-bit number word *(d(nT))* whose most significant bit (MSB) is set to '1' and the remaining bits are set to '0' from the *P''*-bit number word representing the discrete sine amplitude sample values *(s(nT))* at the output ports of the read-only memory (ROM), which yields a *P''*-bit number word representing the discrete signal $a_2(nT) := m(nT) + r(nT)$ |
| S1 | step #1: repeatedly accumulating digital P-bit phase increment values ($\Delta\varphi_s(nT)$), which serve as frequency control words (FCWs), to generate *P'*-bit samples of a digital sawtooth signal ($\varphi_s(nT)$) with a predefined time period (*N·T*) |
| S2 | step #2: executing a phase-to-sine-amplitude conversion of the obtained discrete phase input values ($\varphi_s(nT)$) into a set of discrete sine amplitude sample values (*s(nT)*) |
| S4 | step #4 : converting the resulting sum (a$_n$(nT)) into an approximation of a quantized analog sine wave ($a_1$'(*t*)) |
| S3 | step #3: spreading spurious harmonics (DSCs) over the entire signal spectrum by adding a *P''*-bit number word representation of a random number *(r(nT))* to the obtained sine amplitude sample values *(s(nT))*, thereby destroying the periodical structure of glitches, phase truncation errors and quantization errors $(\tilde{e}(nT))$ of the approximated sine wave $(\tilde{s}(t))$ and transforming its spurious discrete noise power density spectrum ($\tilde{\Phi}_{ee}(kf)$) caused by said error signal $(\tilde{e}(nT))$ into a continuous noise power density spectrum ($\breve{\Phi}_{ee}$(f)) having an approximately constant spectral power density (N$_0$) and the same total noise power (P$_e$) as the original noise power density spectrum ($\tilde{\Phi}_{ee}$(kf)) |
| S5 | step #5: compensating the additive noise by subtracting a digital-to-analog-converted representation of a pseudo-random signal ($a_2(nT)$) containing information about the symmetrical location and power level of the harmonically related spurs (DSCs) from the quantized analog sine wave approximation ($a_1$'(*t*)) at the analog output port of the direct digital frequency synthesizing unit (DDFS), thereby completely removing even-numbered spurious harmonics (DSCs) |
| S6 | step #6: adding a *P''*-bit number word representing the sine amplitude sample values *(s(nT))* to the two's complement of a *P''*-bit number word *(d(nT))* whose most significant bit (MSB) is set to '1' and the remaining bits are set to '0' |

(continued)

| No. | Technical Feature or System Component |
|---|---|
| S7 | step #7: adding the $P''$-bit number word representation of the above random number $(r(nT))$ to the $P''$-bit number word representing the obtained difference signal $(m(nT) := s(nT)-d(nT))$ and feeding the result $(a_2(nT) := m(nT) + r(nT))$ to a digital-to-analog converter $(DAC_2)$ |
| S8 | step #8: converting the obtained set of discrete sample values $(a_2(nT))$ into an analog output signal $(a_2'(t))$ |
| S9 | step #9: subtracting the analog output signal $(a_2'(t))$ of said digital-to-analog converter $(DAC_2)$ from the quantized analog sine wave approximation $(a_1'(t))$ |
| S10 | step #10: suppressing aliasing harmonics in the output signal spectrum $(\overline{\overline{S}}(f))$ of the direct digital frequency synthesizing unit (DDFS) and smoothing the shape of the resultant analog sine wave approximation $(\overline{s}(t))$ by means of a low-pass filter $(LPF_1)$ |
| S11 | step #11: using the output signal $(s(t))$ of the direct digital frequency synthesizing unit (DDFS) for a direct up-conversion of the output signal $(S_{PLL}(t))$ of a phase-locked loop (PLL)-controlled oscillator circuit to be transmitted from the baseband to the passband |
| S12 | step #12: using the output signal $(s(t))$ of the direct digital frequency synthesizing unit (DDFS) for a direct down-conversion (S12) of a received modulated RF signal $(x(t))$ from the passband to the baseband |

**Claims**

1. A direct digital synthesis (DDS) method for generating a quantized analog signal $a_1'(t)$ with an approximately sinusoidal waveshape, comprising the following steps:

   - repeatedly accumulating (S1) digital $P$-bit phase increment values $\Delta\varphi_s(nT)$ to generate $P'$-bit samples of a digital sawtooth signal $\varphi_s(nT)$ with a predefined time period $N \cdot T$,
   - executing (S2) a phase-to-sine-amplitude conversion of the sawtooth signal into a set of discrete sine amplitude sample values $s(nT)$,
   - adding (S3) a $P''$-bit number word representation of a random number $r(nT)$ to the obtained set of discrete sine amplitude sample values $s(nT)$, and
   - converting (S4) the resulting sum $a_1(nT)$ into an approximation of a quantized analog sine wave $a_1'(t)$,

   **characterized by step of**
   subtracting (S5) a digital-to-analog-converted representation $a_2(t)$ of a pseudo-random signal $a_2(nT)$ from the quantized analog sine wave approximation $a_1'(t)$, the pseudo-random signal $a_2(nT)$ being generated by setting (S6) at least the most significant bit (MSB) of a $P''$-bit number word representing said sine amplitude sample values $s(nT)$ to '0' and adding (S7) the $P''$-bit number word representation of the random number $r(nT)$ to the resultant $P''$-bit number word $m(nT)$ of said zero-setting operation.

2. The direct digital synthesis (DDS) method according to claim 1,
   **characterized by**

   the additional step of low-pass-filtering (S10) the output signal spectrum $\breve{S}(f)$ of the direct digital frequency synthesizing unit (DDFS) for suppressing aliasing harmonics (DSCs) and smoothing the shape of the resultant analog sine wave approximation $\breve{s}(t)$.

3. The direct digital synthesis (DDS) method according to anyone of the claims 1 or 2,
   **characterized in that**
   the output signal $\breve{s}(t)$ of the direct digital frequency synthesizing unit (DDFS) is used for a direct up-conversion (S11) of the output signal $s_{PLL}(t)$ of a phase-locked loop (PLL)-controlled oscillator circuit, the resultant analog RF signal

$s_{PLL}$ (t) $\cdot \tilde{s}(t)|_{SSB}$ serving as a carrier signal $c(t)$ for an up-conversion of a baseband signal to be transmitted to the passband.

**4.** The direct digital synthesis (DDS) method according to anyone of the claims 1 or 2,
**characterized in that**
the output signal $\tilde{s}(t)$ of the direct digital frequency synthesizing unit (DDFS) is used for a direct up-conversion (S11) of the output signal $s_{PLL}$(t) of a phase-locked loop (PLL)-controlled oscillator circuit, the resultant analog RF signal $s_{PLL}$(t) $\cdot \tilde{s}(t)|_{SSB}$ serving as a carrier signal $c(t)$ for a down-conversion of a received modulated RF signal from the passband to the baseband.

**5.** The direct digital synthesis (DDS) method according to anyone of the claims 1 to 4,
**characterized in that**
it is executed in an RF transmitting and/or RF receiving unit of a wireless communication device.

**6.** A direct digital frequency synthesizing unit of an electronic device used for generating a quantized analog sine wave $a_1'(t)$ with an approximately sinusoidal waveshape, which is specially designed for performing a method according to anyone of the claims 1 to 4,
comprising

- a phase accumulator (ACC) comprising at least one $P'$-bit register (104) and a digital summation element (102) serving as a discrete integrator for repeatedly accumulating $P$-bit number words representing digital phase increment values $\Delta\varphi_s(nT)$ to generate $P'$-bit samples of a digital sawtooth signal $\varphi_s(nT)$ with a predefined time period $N \cdot T$,
- a read-only memory (ROM) serving as a lookup table (LUT) for a phase-to-sine-amplitude conversion of discrete phase input values $\varphi_s(nT)$ supplied by the phase accumulator (ACC) into a set of discrete sine amplitude sample values $s(nT)$,
- a random number generator (RNG) generating $P''$-bit number words representing digitally encoded pseudo-random numbers $r(nT)$,
- digital summation means ($\Sigma_1$) for adding an obtained $P''$-bit number word representation of a random number $r(nT)$ to the P''-bit number word representing the discrete output signal $s(nT)$ of the read-only memory (ROM) yielding a $P''$-bit number word representing the discrete signal $a_1(nT) := s(nT) + r(nT)$, and
- at least one digital-to-analog converter (DAC$_1$) for converting said sine amplitude sample values $s(nT)$ into a quantized approximation of an analog sine wave $a_1'(t)$.

**characterized by**

- means (402a) for setting (S6) the most significant bit (MSB) of a $P''$-bit number word representing the sine amplitude sample values $s(nT)$ at the output ports of the read-only memory (ROM) to '0',
- a further digital summation element ($\Sigma_2$) for adding (S7) a $P''$-bit number word representation of the random number $r(nT)$ to the resultant $P''$-bit number word $m(nT)$ of said zero-setting operation, which yields a $P''$-bit number word representing the discrete signal $a_2(nT) := m(nT) + r(nT)$,
- a further digital-to-analog converter (DAC$_2$) for converting the discrete sample values $a_2(nT)$ at the output ports of the second digital summation element ($\Sigma_2$) into a quantized analog signal $a_2'(t)$, and
- an analog subtracting element (402b) for calculating the analog difference signal $\Delta a'(t) := a_1'(t) - a_2'(t)$ of the quantized analog signals $a_1'(t)$, $a_2'(t)$ obtained at the output ports of the digital-to-analog converters (DAC$_1$, DAC$_2$), which serves as an analog approximation for the sine wave $s(t)$ to be generated.

**7.** The direct digital frequency synthesizing unit according to claim 6,
**characterized by**
low-pass filtering means (LPF$_1$) for suppressing spurious aliasing harmonics (DSCs) in the resultant output signal spectrum $\tilde{S}(f)$ of the direct digital frequency synthesizing unit (DDFS), thereby smoothing the shape of the obtained analog sine wave $\tilde{s}(t)$ approximation.

**8.** The direct digital frequency synthesizing unit according to anyone of the claims 6 or 7,
**characterized in that**
it is integrated into an RF transmitting and/or RF receiving unit of a wireless communication device.

**Patentansprüche**

1. Direktes digitales Syntheseverfahren (DDS) zur Erzeugung eines quantisierten Analogsignals $a_1'(t)$ mit einer angenähert sinusförmigen Wellenform, welches die folgenden Schritte aufweist:

   - wiederholte Aufsummierung (S1) digitaler P-Bit-Phasenschrittwerte $\Delta\varphi_s(nT)$ zur Erzeugung von $P'$-Bit-Abtastwerten eines digitalen Sägezahnsignals $\varphi_s(nT)$ mit einer festgelegten Zeitdauer $NT$,
   - Ausführung (S2) einer Phase-zu-Sinusamplitude-Umsetzung des Sägezahnsignals in einen Satz diskreter Sinusamplituden-Abtastwerte $s(nT)$,
   - Addition (S3) einer numerischen $P''$-Bit-Wort-Darstellung einer Zufallszahl $r(nT)$ zum erhaltenen Satz diskreter Sinusamplituden-Abtastwerte $s(nT)$, und
   - Umsetzung (S4) der resultierenden Summe $a_1(nT)$ in eine Näherung einer quantisierten analogen Sinuswelle $a_1'(t)$,

   **gekennzeichnet durch** den Schritt der
   Subtraktion (S5) einer digital-zu-analog umgesetzten Darstellung $a_2(t)$ eines Pseudozufallssignals $a_2(nT)$ von der quantisierten analogen Sinuswellennäherung $a_1'(t)$, wobei das Pseudozufallssignal $a_2(nT)$ erzeugt wird, indem mindestens das höchstwertige Bit eines numerischen $P''$-Bit-Worts, welches diese Sinusamplituden-Abtastwerte $s(nT)$ darstellt, auf Null gesetzt (S6) wird, sowie Addition (S7) der numerischen $P''$-Bit-Wort-Darstellung der Zufallszahl $r(nT)$ zu dem aus dem Setzen auf Null resultierenden numerischen $P''$-Bit-Wort $m(nT)$.

2. Direktes digitales Syntheseverfahren (DDS) nach Anspruch 1,
   **gekennzeichnet durch**

   den weiteren Schritt der Tiefpassfilterung (S10) des Ausgangssignalspektrums $\check{S}(f)$ der direkten digitalen Frequenzsynthese-Einheit (DDFS) zur Unterdrückung verfälschender Oberwellen sowie zur Glättung der Form der resultierenden analogen Sinuswellennäherung $\check{S}(t)$.

3. Direktes digitales Syntheseverfahren (DDS) nach einem der Ansprüche 1 oder 2,
   **dadurch gekennzeichnet,**
   **dass** das Ausgangssignal $\check{s}(t)$ der direkten digitalen Frequenzsynthese-Einheit (DDFS) für eine direkte Aufwärtsmischung (S11) des Ausgangssignals $s_{PLL}(t)$ einer phasemegelkreisgesteuerten Oszillatorschaltung verwendet wird, wobei das resultierende analoge RF-Signal $S_{PLL}(t)\,\check{S}(t)|_{SSB}$ als ein Trägersignal $c(t)$ für eine Aufwärtsmischung eines an den Durchlassbereich zu übertragenden Basisbandsignals dient.

4. Direktes digitales Syntheseverfahren (DDS) nach einem der Ansprüche 1 oder 2,
   **dadurch gekennzeichnet,**
   **dass** das Ausgangssignal $s(t)$ der direkten digitalen Frequenzsynthese-Einheit (DDFS) für eine direkte Aufwärtsmischung (S11) des Ausgangssignals $S_{PLL}(t)$ einer phasenregelkreisgesteuerten Oszillatorschaltung verwendet wird, wobei das resultierende analoge RF-Signal $S_{PLL}(t)\,\check{S}(t)|_{SSB}$ als ein Trägersignal $c(t)$ für eine Abwärtsmischung eines empfangenen modulierten RF-Signals vom Durchlassbereich zum Basisband dient.

5. Direktes digitales Syntheseverfahren (DDS) nach einem der Ansprüche 1 bis 4,
   **dadurch gekennzeichnet,**
   **dass** es in einer RF-Sende- und/oder RF-Empfangseinheit eines drahtlosen Kommunikationsgeräts ausgeführt wird.

6. Direkte digitale Frequenzsynthese-Einheit eines elektronischen Geräts zur Erzeugung einer quantisierten analogen Sinuswelle $a_1'(t)$ mit einer angenähert sinusförmigen Wellenform, welche speziell zur Ausführung eines Verfahrens nach einem der Ansprüche 1 bis 4 ausgelegt ist,
   aufweisend:

   - einen Phasenakkumulator (ACC) zur Erzeugung von P'-Bit-Abtastwerten eines digitalen Sägezahnsignals $\varphi_s(nT)$ mit einer festgelegten Zeitdauer $NT$, welcher mindestens ein $P'$-Bit-Register (104) und ein digitales Additionselement (102) enthält, welches dazu dient, als diskreter Integrator numerische $P$-Bit-Wörter, welche digitale $P$-Bit Phasenschrittwerte $\Delta\varphi_s(nT)$ darstellen, wiederholt aufzusummieren,
   - einen Festwertspeicher (ROM), welcher als Verweistabelle für eine Phase-zu-Sinusamplitude-Umsetzung der vom Phasenakkumulator (ACC) zugeführten diskreten Phaseneingangswerte $\varphi_S(nT)$ in einen Satz von diskreten Sinusamplituden-Abtastwerten $s(nT)$ dient,

- einen Zufallszahlengenerator (RNG) zur Erzeugung numerischer $P''$-Bit-Wörter, welche digital codierte Pseudozufallszahlen $r(nT)$ darstellen,

- ein digitales Additionsmittel ($\Sigma_1$) zur Addition einer erhaltenen numerischen $P''$-Bit-Wortdarstellung einer Zufallszahl $r(nT)$ zum numerischen $P''$-Bit-Wort, welches das diskrete Ausgangssignal $s(nT)$ des Festwertspeichers darstellt, wobei sich ein numerisches $P''$-Bit-Wort ergibt, welches das diskrete Signal $a_1(nT) := s(nT) + r(nT)$ darstellt, und

- mindestens einen Digital-Analog-Umsetzer ($DAC_1$) zur Umsetzung der Sinusamplituden-Abtastwerte $s(nT)$ in eine quantisierte Näherung einer analogen Sinuswelle $a_1'(t)$,

**gekennzeichnet durch**

- Mittel (402a), um das höchstwertige Bit eines numerischen $P''$-Bit-Worts, welches die Sinusamplituden-Abtastwerte $s(nT)$ an den Ausgangsanschlüssen des Festwertspeichers (ROM) darstellt, auf '0' zu setzen (S6),

- ein weiteres digitales Additionsmittel ($\Sigma_2$) zur Addition (S7) einer numerischen $P''$-Bit-Wortdarstellung der Zufallszahl $r(nT)$ zu dem aus dem Setzen auf Null resultierenden numerischen $P''$-Bit-Wort $m(nT)$, wobei sich ein numerisches $P''$-Bit-Wort ergibt, welches das diskrete Signal $a_2(nT) := m(nT) + r(nT)$ darstellt,

- einen weiteren Digital-Analog-Umsetzer ($DAC_2$) zur Umsetzung der diskreten Abtastwerte $a_2(nT)$ an den Ausgangsanschlüssen des zweiten Additionselements ($\Sigma_2$) in ein quantisiertes Analogsignal $a_2'(t)$, und

- analoges Subtraktionselement (402b) zur Berechnung des analogen Differenzsignals $\Delta a'(nT) := a_1'(t) - a_2'(t)$ der an den Ausgangsanschlüssen der Digital-Analog-Umsetzer ($DAC_1$, $DAC_2$) erhaltenen quantisierten Analogsignale $a_1'(t)$, $a_2'(t)$, welches als eine analoge Näherung für die zu erzeugende Sinuswelle $s(t)$ dient.

7. Direkte digitale Frequenzsynthese-Einheit nach Anspruch 6,
**gekennzeichnet durch**
Tiefpass-Filterungsmittel ($LPF_1$) zur Unterdrückung unerwünschter verfälschender Oberwellen (DSCs) im resultierenden Ausgangssignalspektrum $\check{S}(f)$ der direkten digitalen Frequenzsynthese-Einheit (DDFS), wobei die Form der erhaltenen analogen Sinuswellennäherung $\check{s}(t)$ geglättet wird.

8. Direkte digitale Frequenzsynthese-Einheit nach einem der Ansprüche 6 oder 7,
**dadurch gekennzeichnet,**
**dass** sie in eine RF-Sende- und/oder RF-Empfangseinheit eines drahtlosen Kommunikationsgeräts integriert ist.

**Revendications**

1. Procédé de synthèse numérique directe (DDS) destiné à engendrer un signal analogique quantifié $a_1'(t)$ avec une forme d'onde à peu près sinusoïdale, comprenant les étapes suivantes :

de cumul répété (S1) de valeurs numériques $\Delta\varphi_s(nT)$ d'incrément de phase à $P$ bits pour engendrer des échantillons à $P'$ bits d'un signal numérique $\varphi_s(nT)$ en dents de scie avec une période temporelle prédéfinie $N.T$ ;
d'exécution (S2) d'une conversion de phase en amplitude sinusoïdale du signal en dents de scie en un ensemble de valeurs discrètes $s(nT)$ d'échantillons d'amplitude sinusoïdale ;
d'addition (S3) d'une représentation de mot d'un nombre $P''$ de bits d'un nombre aléatoire $r(nT)$ à l'ensemble obtenu de valeurs discrètes $s(nT)$ d'échantillons d'amplitude sinusoïdale ; et
de conversion (S4) de la somme résultante $a_1(nT)$ en une approximation d'une onde sinusoïdale analogique quantifiée $a_1'(t)$;

**caractérisé par** l'étape (S5) consistant à soustraire, de l'approximation $a_1'(t)$ d'onde sinusoïdale analogique quantifiée, une représentation $a_2(t)$ convertie de numérique en analogique d'un signal pseudo-aléatoire $a_2(nT)$, le signal pseudo-aléatoire $a_2(nT)$ étant engendré en mettant à '0' (S6) au moins le bit de poids le plus fort (MSB) d'un mot d'un nombre $P''$ de bits représentant lesdites valeurs $s(nT)$ d'échantillons d'amplitude sinusoïdale, et à additionner (S7) la représentation de mot d'un nombre $P''$ de bits du nombre aléatoire $r(nT)$ au mot $m(nT)$ d'un nombre $P''$ de bits résultant de ladite opération de mise à zéro.

2. Procédé de synthèse numérique directe (DDS) selon a revendication 1,

**caractérisé par** l'étape supplémentaire de filtrage passe-bas (S10) du spectre $\check{S}(f)$ de signal de sortie de l'unité de synthèse de fréquence numérique directe (DDFS) pour atténuer les harmoniques (DSC) de crénelage et pour lisser la forme de l'approximation $\breve{s}$ *(t)* d'onde sinusoïdale analogique résultante.

3. Procédé de synthèse numérique directe (DDS) selon la revendication 1 ou 2,
   **caractérisé en ce que** le signal $\tilde{s}(t)$ de sortie de l'unité de synthèse de fréquence numérique directe (DDFS) est utilisé pour l'élévation en fréquence directe (S11) du signal de sortie $S_{PLL}$ *(t)* d'un circuit oscillateur commandé par boucle à phase asservie (PLL), le signal HF analogique résultant s$_{PLL}$(t). $\tilde{s}(t)$ |$_{SSB}$ servant de signal *c(t)* de porteuse pour une élévation en fréquence, jusqu'à la bande passante, d'un signal en bande de base à émettre.

4. Procédé de synthèse numérique directe (DDS) selon la revendication 1 ou 2,
   **caractérisé en ce que** le signal $\tilde{s}(t)$ de sortie de l'unité de synthèse de fréquence numérique directe (DDFS) est utilisé pour l'élévation en fréquence directe (S11) du signal de sortie $S_{PLL}(t)$ d'un circuit oscillateur commandé par boucle à phase asservie (PLL), le signal HF analogique résultant S$_{PLL}$(t). $\tilde{s}(t)$|$_{SSB}$ servant de signal *c(t)* de porteuse pour un abaissement en fréquence, de la bande passante à la bande de base, d'un signal HF modulé reçu.

5. Procédé de synthèse numérique directe (DDS) selon l'une quelconque des revendications 1 à 4,
   **caractérisé en ce qu'**il est exécuté dans une unité d'émission HF et/ou de réception HF d'un dispositif de communication sans fil.

6. Unité de synthèse de fréquence numérique directe d'un dispositif électronique utilisé pour engendrer une onde sinusoïdale analogique quantifiée $a_1'(t)$ avec une forme d'onde à peu près sinusoïdale, qui est conçue spécialement pour mettre en oeuvre un procédé selon l'une quelconque des revendications 1 à 4, comprenant :

   un accumulateur (ACC) de phase comprenant au moins un registre (104) à *P'* bits et un élément (102) de sommation numérique servant d'intégrateur discret pour cumuler de façon répétée des mots d'un nombre *P* de bits représentant des valeurs numériques $\Delta\varphi_s(nT)$ d'incrément de phase pour engendrer des échantillons à *P'* bits d'un signal numérique $\varphi_s(nT)$ en dents de scie avec une période temporelle prédéfinie *N.T ;*
   une mémoire morte (ROM) servant de table de consultation (LUT) pour une conversion de phase en amplitude sinusoïdale de valeurs discrètes $\varphi_s(nT)$ d'entrée de phase délivrées par l'accumulateur (ACC) de phase en un ensemble de valeurs discrètes *s(nT)* d'échantillons d'amplitude sinusoïdale ;
   un générateur (RNG) de nombres aléatoires engendrant des mots d'un nombre *P''* de bits représentant des nombres pseudo-aléatoires *r(nT)* codés de manière numérique ;
   un moyen ($\Sigma_1$) de sommation numérique destiné à additionner une représentation obtenue de mot d'un nombre *P''* de bits d'un nombre aléatoire *r(nT)* au mot d'un nombre *P''* de bits représentant le signal discret *s(nT)* de sortie de la mémoire morte (ROM) en donnant un mot d'un nombre P'' de bits représentant le signal discret $a_1$ *(nT)* : = *s (nT) + r(nT) ;* et
   au moins un convertisseur (DAC$_1$) de numérique en analogique destiné à convertir lesdites valeurs *s(nT)* d'échantillons d'amplitude sinusoïdale en une approximation quantifiée d'une onde sinusoïdale analogique $a_1'$ *(t),*

   **caractérisée par**

   un moyen (402a) destiné à mettre à '0' (S6) le bit de poids le plus fort (MSB) d'un mot d'un nombre *P''* de bits représentant les valeurs *s(nT)* d'échantillons d'amplitude sinusoïdale au niveau de ports de sortie de la mémoire morte (ROM) ;
   un élément supplémentaire ($\Sigma_2$) de sommation numérique destiné à additionner (S7) une représentation de mot d'un nombre *P''* de bits du nombre aléatoire *r(nT)* au mot *m(nT)* d'un nombre *P''* de bits résultant de ladite opération de mise à zéro, ce qui donne un mot d'un nombre P'' de bits représentant le signal discret $a_2(nT)$ : = *m(nT) + r(nT) ;*
   un convertisseur supplémentaire (DAC$_2$) de numérique en analogique destiné à convertir les valeurs discrètes $a_2(nT)$ d'échantillons au niveau des ports de sortie du second élément ($\Sigma_2$) de sommation en un signal analogique quantifié a$_2$'(t) ; et
   un élément analogique (402b) de soustraction destiné à calculer le signal analogique $\Delta a'(t)$*:* = $a_1$'(t) - $a_2$'(t) de différence des signaux analogiques quantifiés $a_1$'(t), $a_2'$ *(t)* obtenus au niveau des ports de sortie des convertisseurs (DAC$_1$, DAC$_2$) de numérique en analogique, lequel sert d'approximation analogique pour l'onde sinusoïdale *s(t)* à engendrer.

7. Unité de synthèse de fréquence numérique directe selon la revendication 6 ;

**caractérisée par** un moyen (LPF$_1$) de filtrage passe-bas destiné à atténuer des harmoniques parasites (DSC) de crénelage dans le spectre $\breve{S}$ (f) de signal de sortie résultant de l'unité de synthèse de fréquence numérique directe (DDFS), en lissant ainsi la forme de l'approximation d'onde sinusoïdale analogique $\breve{s}$ (t) obtenue.

8. Unité de synthèse de fréquence numérique directe selon l'une quelconque des revendications 6 ou 7, **caractérisée en ce qu'**elle est intégrée dans une unité d'émission HF et/ou de réception HF d'un dispositif de communication sans fil.

FIG 1A

100a

FCW:
$\Delta\varphi_S(nT)$

Clock Signal:

$\text{Ш}(t), f_{clk} = \frac{1}{T}$

$(\text{Ш}(t) = \sum_{n=-\infty}^{\infty} \delta(t-nT))$

$\varphi_S(nT)$

$s(nT) = \sin[\varphi_S(nT)]$

Analog Sine Wave Approximation

$\tilde{s}(t)$
$f_{DDS}$

DDFS

LPF$_1$

$s'(t)$

DAC$_1$

ROM

P''
2)

ACC

P'
1)

P

FIG 1B

100b

FCW:
$\Delta\varphi_S(nT)$

P

$\Sigma$
102

P

P'

REG
104

P'

$\varphi_S(nT)$

FIG 1C

100c

$s_{REF}(t)$
$f_{REF}$

106a

106b

LPF$_2$

106c

VCO

$s_{PLL}(t)$
$f_{PLL}$

108

SSB Mixer

RF Output Signal
$\hat{=}$ Carrier Signal c(t)
$f_{OUT}$

DDFS
100a

$\div N$
106d

PLL 106

Signal Errors: 1) Phase Truncation (numerical)
2) Amplitude Quantization (distortions)

21

## FIG 1D

$$f(t) = \frac{1}{2\pi} \cdot \frac{d\varphi(t)}{dt}$$

## FIG 1E

| Phase Accumulator Output | Phase-to-Amplitude Converter Output | D/A Converter Output | Filter Output |
|---|---|---|---|

EP 1 469 373 B1

# FIG 2A

200a

**Sine Wave Generation Stage**

100a

ACC ROM

FCW:
$\Delta\varphi_S(nT)$

DDFS Logic → DAC$_1$ → s'(t) → LPF$_1$

Clock Signal:
$\text{Ⅲ}(t), f_{clk} = \frac{1}{T}$

$\widetilde{s}(t)$
$f_{DDS}$

**8-fold Multiplication Stage**

204c    202c    204b    202b    204a    202a

≈ → Doubler → ≈ → Doubler → ≈ → Doubler ←

201a

**Up-Conversion Stage**

206    208    201b

Up-Converter → ≈ → Carrier Signal c(t)
($f_{OUT} = 1.890...1.910$ MHz)

LO Signal
($f_{LO} = 1.810$ MHz)

LO ≈

210

## FIG 2B

Sine Function Generator

# FIG 3

Maximum Spurious
Level: -69,63 dBc
@10,06 MHz

300

0,5 MHz/10 dBc per division
center: $f_C = 11,25$ MHz
span: $\Delta f_S = 5,00$ MHz

**FIG 4**

EP 1 469 373 B1